# EUROPEAN PATENT APPLICATION

(11) **EP 2 620 519 A1**
(43) Date of publication of application: **31.07.2013**
(21) Application number: 13152317.7
(22) Date of filing: 23.01.2013
(51) Int. Cl.: C23C 16/50, C23C 16/54, C23C 16/40, H01J 37/32, C23C 16/04

(54) **Vacuum deposition apparatus**

(30) Priority: 24.01.2012 JP 2012012036
(71) Applicant: Kabushiki Kaisha Kobe Seiko Sho (Kobe Steel, Ltd.), Kobe-shi, Hyogo 651-8585 (JP)
(72) Inventor: Okimoto, Tadao, Takasago-shi, Hyogo 676-8670 (JP); Tamagaki, Hiroshi, Takasago-shi, Hyogo 676-8670 (JP)
(74) Representative: TBK

(57) **Abstract**

Provided is a vacuum deposition apparatus (1) including a vacuum chamber (4), a deposition roller (2) that is arranged in the vacuum chamber, and winds a substrate (W) in a sheet form subject to deposition, and a magnetic field generation unit (8) that is provided inside the deposition roller, and generates a magnetic field on a surface of the deposition roller, where the magnetic field generation unit includes an inside magnet arranged along an axial direction of the deposition roller and an outside magnet having a polarity opposite to the inside magnet and surrounding, in an annular form, the inside magnet, and the inside magnet is formed so as to be narrower in width along the axial direction of the deposition roller than a width of an extent of winding of the substrate W on the deposition roller in a projection viewed from a deposition surface of the substrate, and is arranged within the extent of the winding of the substrate W.

## Description

### BACKGROUND OF THE INVENTION

### (FIELD OF THE INVENTION)

The present invention relates to a vacuum deposition apparatus for depositing a thin coating on a surface of a substrate by impressing a voltage on the substrate in a vacuum state.

### (DESCRIPTION OF THE RELATED ART)

A property of blocking vapor and oxygen (high barrier property) recently tends to be required for a plastic film used for packing foods. In order to impart the high barrier property to a substrate (sheet material) such as a plastic film, it is necessary to coat (cover) the substrate with a coating such as SiOx and Al₂O₃ having a transparent property. As a coating technology for the SiOx coating, the physical vapor deposition method (PVD method) such as the vacuum deposition method and the sputtering method, and the plasma CVD method which is advantageous in a deposition speed and deposition of a high barrier coating compared with the physical vapor deposition method (PVD method) are recently used for a vacuum deposition apparatus.

Out of the above vapor deposition methods, as the vacuum deposition apparatus employing the plasma CVD method, there are those described in US 2010/313810, Japanese Patent Application Laid-Open No. 2011-149059, Japanese Patent Application Laid-Open No. 2009-24205, Published Japanese Translation of PCT application No. 2005-504880, and US Patent No. 5224441.

The apparatuses disclosed in the prior documents include a pair of deposition rollers electrically connected to two poles of an AC power supply, thereby applying an electric potential difference between the pair of deposition rollers, and magnets generating a magnetic field on a roller surface are arranged inside each of the rollers. Then, plasma is generated on the surface of the rollers by an interaction between the magnetic field and the electric potential difference, thereby enabling deposition of a CVD coating on a sheet material W (substrate W).

When a coating is deposited on the substrate (film) wound on the deposition rollers by the vacuum deposition apparatus in the each of the prior documents, the coating is also deposited on portions of a surface of the deposition roller on which the film is not wound, namely both end portions of the roller.

This is because discharge extent of the plasma is intentionally increased wider than the width of the substrate, thereby passing the substrate through a portion where the plasma discharge is uniform in order to obtain a uniform coating thickness distribution on the substrate. As a result, the plasma protrudes to the outside of the substrate, and a large quantity of the undesired coating is deposited on the end portions of the roller.

Moreover, according to the plasma CVD for supplying electricity to the roller, thereby generating plasma, in order to equalize electric properties between a substrate portion on which the substrate is wound on the roller surface and both sides on which the substrate is not wound on the roller surface, an insulating material as thick as the substrate needs to be formed on both end portions of the roller. Since the thickness of the insulating material is as thin as the substrate, a large current flows through the both end portions of the roller, thereby generating strong plasma, resulting in a deposition of a thick coating on the both end portions of the roller.

Further, if plasma wider than the width of the wound substrate is generated, strong plasma is generated also on the portions of the ends of the substrate, resulting in a damage of the portions of the ends of the substrate, which tends to generate dielectric breakdown. Though a method for restrictively generating plasma at a substrate center portion remote from the ends of the substrate is conceivable, simply weakening the plasma at the edges of the substrate decreases the quantity of the deposition attached to the substrate close to the edges of the substrate. This results in an insufficient coating thickness used for the barrier coating and the like in the neighborhood of the ends of the substrate, the neighborhood is cut off and discarded, and the usage efficiency of the material decreases, constituting a disadvantage in terms of economy.

An apparatus for restraining the undesired deposition on the roller sides and preventing the damage on the substrate sides while uniformly deposition in the widthwise direction on the substrate is necessary.

The prior documents do not disclose or suggest means for solution regarding the restraint of the deposition on the both end portions of the roller.

Though the inventors of this application have developed a vacuum deposition apparatus in which magnets arranged in each of rollers have a characteristic configuration with respect to the width of a film, thereby restraining the deposition on both end portions of the rollers, the prior documents do not include disclosure or suggestion which enables the technology to occur.

In other words, US 2010/313810 and Japanese Patent Application Laid-Open No. 2011-149059 do not disclose a relative relationship between the configuration of the magnets arranged inside each of the rollers and the width of the film. Japanese Patent Application Laid-Open No. 2009-24205 does not disclose a magnet arranged inside the rollers in the first place. Published Japanese Translation of PCT application No. 2005-504880 discloses a relative relationship between a size of a magnet and the width of the film in an example for generating plasma by means of the Penning discharge, and does not disclose a configuration of a race-track magnet considering a size of the plasma. In the Penning discharge, magnetic lines of force exiting from a deposition roller extend to an opposing roller, and the magnetic line does not exit from and enter a surface of the deposition rollers. The plasma is generated at a location separated from the deposition rollers, and the coating is not brought into a fine state by the plasma. Moreover, in the Penning discharge, an outside magnet is not included, a magnetic field at the edges of the substrate cannot be controlled to actively prevent the damage on the edges of the substrate, and the coating thickness in a neighborhood of the edges of the substrate cannot be controlled. US Patent No. 5224441 discloses a type of the CVD processing apparatus in which a magnetron is embedded in an electrode opposed to the roller, and does not disclose the relative relationship between the configuration of the magnet arranged inside a roller and the width of a film.

### SUMMARY OF THE INVENTION

The present invention is devised in view of the foregoing problem, and has an object to provide a vacuum deposition apparatus which selectively generates plasma on a substrate (film) thereby depositing a uniform coating within an extent as wide as possible, restrains the plasma on sides of rollers, thereby restraining the quantity of an attached coating, resulting in a reduction in frequency of maintenance, and restrains the dielectric breakdown on the edges of the substrate.

In order to solve the problems, the vacuum deposition apparatus according to the present invention takes the following technical measures.

In other words, a vacuum deposition apparatus according to the present invention includes a vacuum chamber, a deposition roller that is arranged in the vacuum chamber, and winds a substrate in a sheet form subject to deposition, a magnetic field generation unit that is provided inside the deposition roller, and generates a magnetic field on a surface of the deposition roller, a gas supply unit that supplies a source gas into the vacuum chamber, and a power supply that generates a discharge for bringing the source gas into plasma, where the magnetic field generation unit includes an inside magnet arranged along an axial direction of the deposition roller and an outside magnet having a polarity opposite to the inside magnet and surrounding, in an annular form, the inside magnet, and the inside magnet is formed so as to be narrower in width along the axial direction of the deposition roller than a width of an extent of winding of the substrate on the deposition roller in a projection viewed from a deposition surface of the substrate, and is arranged within the extent of the winding of the substrate.

Preferably, magnetic lines of force extending to the outside of the roller on an edge of the substrate in contact with the deposition roller is inclined toward the edge of the deposition roller as viewed in a direction from the outside magnet to the inside magnet.

Preferably, an end portion of the deposition roller is provided with an insulator, and the insulator covers the end portions of the deposition roller so that the outer diameter of said insulator is equal to the diameter of a center portion of said deposition roller.

Preferably, the vacuum deposition apparatus includes two deposition rollers opposed to each other as the deposition roller.

Preferably, the power supply is a mid-frequency AC power supply, one pole thereof is connected to one deposition roller, and the other pole is connected to the other deposition roller, thereby configuring polarities to be different from each other.

Preferably, the vacuum deposition apparatus includes a mask including an opening window narrower than the width of the substrate, where the mask covers the deposition roller so as to cover both ends in a widthwise direction of the substrate and to expose the wound substrate from the opening window.

Preferably, the mask is made of a metal, and is the same in electric potential as the vacuum chamber.

Preferably, the mask is made of a nonmagnetic metal.

Preferably, the mask is formed of an insulating material.

Preferably, the mask includes an opening as the opening window, the opening is provided at a position opposed to a magnetic field generation portion across a surface of the deposition roller, exposes the wound substrate from the opening, and covers the deposition roller with a portion other than the opening along a travelling direction of the substrate.

Preferably, the vacuum deposition apparatus includes cooling means that cools the mask.

The vacuum deposition apparatus according to the present invention can deposit a uniform coating on a substrate (film), and restrains the quantity of the coating attached to the sides of rollers, thereby reducing the frequency of maintenance.

### BRIEF DESCRIPTION OF THE DRAWINGS

Fig. 1 is a diagram illustrating an inside of a plasma CVD apparatus;
Fig. 2 is a perspective view of a magnetic field generation unit according to a first embodiment of the present invention;
Figs. 3A and 3B are views showing the magnetic field generation unit according to the first embodiment, in which Fig. 3A is a plan view of the magnetic field generation unit and Fig. 3B is a side cross sectional view of the magnetic field generation unit;
Fig. 4 is an enlarged cross sectional view of a neighborhood of deposition rollers of the plasma CVD apparatus;
Fig. 5 is a side cross sectional view of the magnetic field generation unit according to a second embodiment of the present invention;
Figs. 6A and 6B are perspective views of masks according to the second embodiment;
Fig. 7 is an enlarged cross sectional view of a neighborhood of deposition rollers of the plasma CVD apparatus (variation); and
Fig. 8 is a view showing an arrangement and a configuration of an outside magnet formed so as to become narrower along an axial direction of the deposition roller.

### DESCRIPTION OF THE PREFERRED EMBODIMENTS

A description will now be given of a plasma CVD apparatus according to embodiments of the present invention as an example of a vacuum deposition apparatus referring to drawings.

### [First Embodiment]

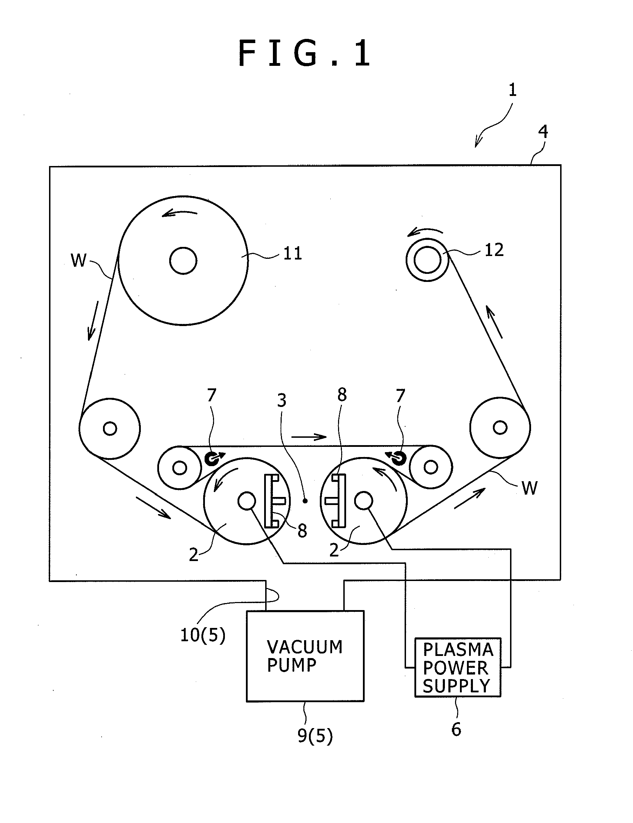

Fig. 1 shows an overall configuration of a plasma CVD apparatus 1 according to a first embodiment of the present invention.

The plasma CVD apparatus 1 (hereinafter simply referred to as CVD apparatus 1) according to this embodiment impresses an alternative current or a pulse voltage inverting polarity on a pair of two deposition rollers 2 arranged so as to oppose to each other approximately in parallel under a decompressed condition, generates a glow discharge in an opposing space 3 between the deposition rollers 2, and carries out deposition by means of the plasma CVD on a substrate (film) W in a sheet form wound on the deposition rollers 2.

The CVD apparatus 1 includes a vacuum chamber 4 in a housing form having a cavity inside. The vacuum chamber 4 can be depressurized to a vacuum state or a low pressure state by vacuum evacuation means 5. The vacuum evacuation means 5 is constructed by a vacuum pump 9 and an exhaust opening 10. The pair of deposition rollers 2 is arranged so that shaft centers thereof are directed in the horizontal direction (in a direction penetrating the page in Fig. 1) and the deposition rollers 2 are separated from each other in the horizontal direction in the vacuum chamber 4. The deposition rollers 2 can rotate forward and backward. Both poles of the plasma power supply 6 are connected respectively to the pair of deposition rollers 2, and a substrate W in a sheet form subject to the deposition is wound on the deposition rollers 2.

A magnetic field generation unit 8 for generating plasma P between the opposing deposition rollers 2 is provided inside each of the deposition rollers 2. A detailed description will later be given of a configuration of the magnetic field generation unit 8.

The CVD apparatus 1 includes a gas supply unit 7 which feeds a source gas into the vacuum chamber 4, and carries out discharge in the magnetic field generated by the magnetic field generation units 8 of the deposition rollers 2 while feeding the source gas from the gas supply unit 7. The CVD apparatus 1 then deposits a CVD coating on the substrate W by passing the substrate W through the plasma P of the source gas generated by the discharge.

The vacuum chamber 4 is formed in a box shape having the cavity inside, and can keep the inside highly airtight with respect to the outside. The vacuum pump 9 of the vacuum evacuation means 5 which evacuates the inside of the vacuum chamber 4 to approximately a vacuum state is provided underside the vacuum chamber 4.

The vacuum evacuation means 5 is constructed by the exhaust opening 10 formed on a partition underside the vacuum chamber 4, and the vacuum pump 9 attached to the exhaust opening 10. The vacuum evacuation means 5 can evacuate the inside of the vacuum chamber 4 to the vacuum state or a lower pressure state close to the vacuum state in response to an instruction from the outside. The source gas is fed from the gas supply unit 7 into the inside of the vacuum chamber 4 brought into the vacuum (low pressure) state by the vacuum evacuation means 5.

A film or sheet made of a plastic, paper, and a non-conducting material which can be wound into a roll form are conceivable as the substrate W subject to the CVD deposition. However, an electrically conductive substrate W can be used by treatment such as bringing various rollers used for transporting the substrate W into an insulated state. The substrate W is wound up into a roll form, and is mounted on a wind-off roller 11 (which serves as a wind-up roller if the transportation is carried out in the opposite direction) arranged in the vacuum chamber 4. The substrate W is wound up into a coil form by a wind-up roller 12 (which serves as a winding-off roller if the transportation is carried out in the opposite direction) in the vacuum chamber 4 after the CVD deposition.

The pair of deposition rollers 2 have cylindrical bodies approximately the same in diameter, the same in length, and formed by a stainless material or the like, and the centers of rotation thereof are approximately the same in height from a bottom surface of the vacuum chamber 4 (top surface of the lower partition). The pair of deposition rollers 2 are separated from each other in the horizontal direction so that shaft centers thereof are approximately parallel with each other, and an opposing space 3 in which the outer peripheral surfaces of the rollers are opposed to each other is formed between both the deposition rollers 2.

The deposition roller 2 is formed so as to be wider than a substrate W having the widest width out of substrates W which can be wound so that substrates W in various widthwise dimensions can be wound.

Both of the pair of deposition rollers 2 is electrically insulated from the vacuum chamber 4, and the rollers are arranged so as to be electrically insulated from each other via the opposing space 3 as described above. Then, one pole of the plasma power supply 6 is connected to one of the pair of deposition rollers 2, and the other pole is connected to the other deposition roller 2 so that the pair of rollers 2 is different in polarity from each other.

The plasma power supply 6 can generate a high-frequency AC voltage or a voltage in a pulse form (DC voltage in pulse form) which can invert the polarity of both of the poles. The both poles of the plasma power supply 6 are insulated from the vacuum chamber 4. If the substrate W subject to the deposition is an insulating material, though a current cannot be flown by impressing a DC voltage, a proper frequency according to the thickness of the film (substrate W) (approximately 1kHz or higher, preferably 10kHz or higher) can provide conduction through the substrate W.

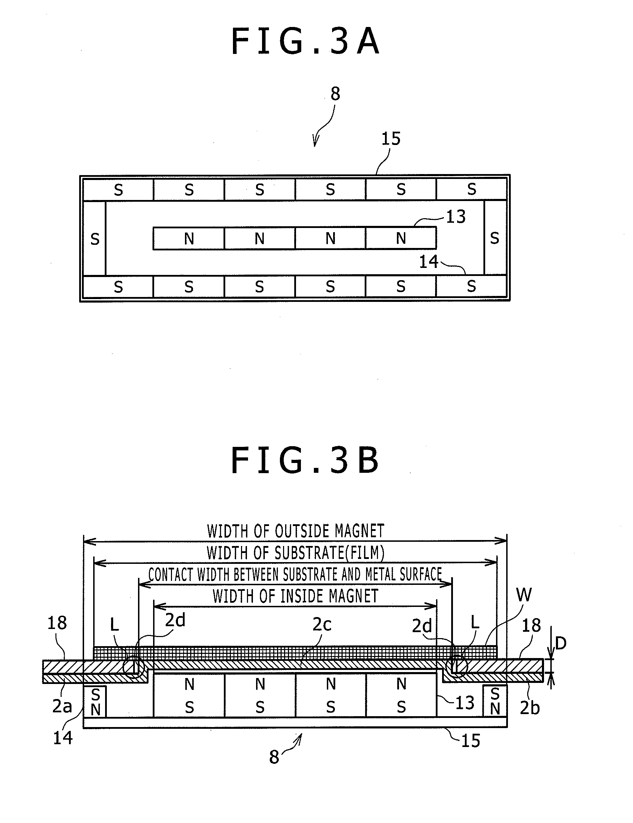

By the way, the deposition roller 2 of the CVD apparatus 1 according to this embodiment is formed so that the both sides 2a and 2b are smaller in diameter than a center portion 2c as shown in Fig. 3B, and each of the sides 2a and 2b is provided with a shield member 18 (insulator) described later.

The shield member 18 is a member which shields/insulates the surfaces of the sides 2a and 2b of the deposition roller 2 from the plasma P, and is formed into a cylindrical shape. A material and a thickness D of the shield member 18 are preferably selected to insulate the substrate W on the surface of the deposition roller 2 from the high-frequency current of the deposition roller 2, and are preferably formed by a material having the same electrical property (insulation property) as that of the substrate W.

The shield member 18 is formed into a cylindrical shape so that the outer diameter thereof is approximately the same as the outer diameter of the center portion 2c of the deposition roller 2, and the inner diameter thereof is approximately the same as the outer diameter of the sides 2a and 2b of the deposition roller 2 formed smaller in diameter. In other words, the shield member 18 is attached so as to have the inner diameter approximately the same as the sides 2a and 2b of the deposition roller 2 formed smaller in diameter. On this occasion, intervals (gaps) L are preferably provided between the shield members 18 and the center portion 2c of the deposition roller 2. The gap L acts so that a strong electric field is not formed at a corner portion connecting the center portion 2c and a step surface 2d.

Moreover, once the shield members 18 are attached to the sides 2a and 2b of the deposition roller 2, an outer diameter of the shield member 18 is approximately equal to an outer diameter of the center portion 2c of the deposition roller 2, an outer peripheral surface of the shield member 18 and an outer peripheral surface of the center portion 2c of the deposition roller 2 flush with each other, and even if the substrate W is wound across the outer peripheral surface of the shield member 18 and the center portion 2c, the substrate W does not present deformation.

The substrate W is wound on the deposition roller 2 so as to partially overlap the shield members 18. The length of the overlap between the substrate W and the shield member 18 is 1-20mm in length along the axial direction of the deposition roller 2. A sufficient coating is not deposited on the portions overlapping the shield members 18, the overlapping portions are preferably short, and the length of the overlapping portion is more preferably 2-10mm so as to restrain the overlapping portion from being absent due to meandering of the substrate W caused by the transport. If the overlapping portion is absent, an abnormal discharge is generated, resulting in an unfavorable condition.

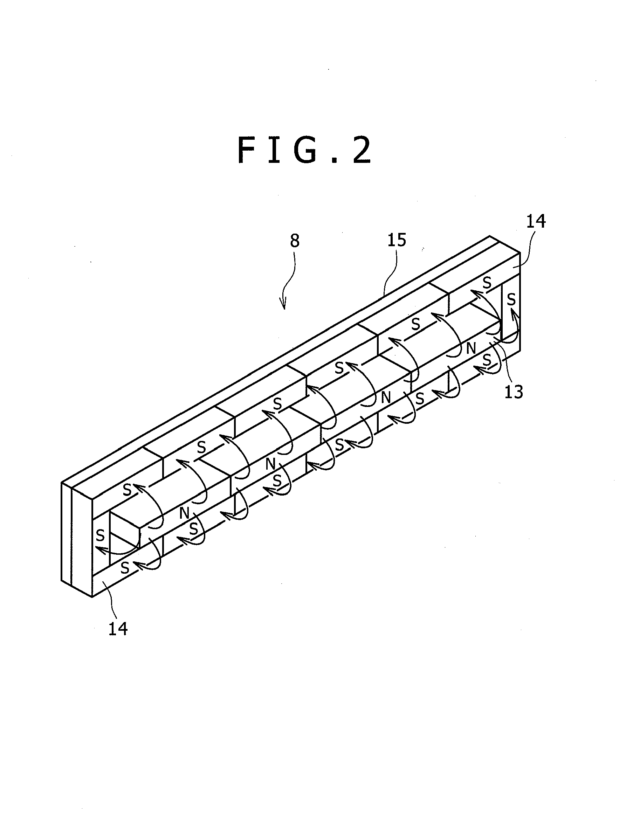

A description will now be given of a configuration of the magnetic field generation unit 8 referring to Figs. 2 and 3.

The magnetic field generation unit 8 is inside the deposition roller 2, and serves to use magnets to generate a magnetic field close to the surface of the deposition roller 2, and to converge the plasma P using the generated magnetic field.

The magnetic field generation unit 8 is designed so as to uniformly deposit the coating on as wide an effective deposition zone as possible on the substrate W, the coating is prevented from being deposited on the surface of the shield members 18 as much as possible, and the plasma P is generated on the surface of the substrate W so as to be as wide as possible.

If the width of the plasma P is narrow, the zone on which the coating is deposited becomes narrow, unnecessary portions on which the coating is not deposited increase on the ends of the substrate W, and the substrate W cannot be efficiently used, resulting in an unfavorable condition in terms of economy.

Conversely, if the plasma P wider than the wound substrate W is generated, strong plasma P is generated on the edges of the substrate W, and a damage is generated on the edges of the substrate W, which tends to generate dielectric breakdown. Though operation can be carried out while the electric power or the voltage is decreased, thereby weakening the plasma P in order to prevent the damage, there poses such problems as a decrease in the productivity and the like.

Moreover, if the plasma P extends wider than the width of the substrate W, an unnecessary coating is deposited on the roller sides on which the substrate W is not wound, dust generated by a thick deposited coating being detached increases defect generated on the coating deposited on the substrate W, or increases a time required for maintenance of removing the dust, which is not preferred.

Then, the magnetic field generation unit 8 is designed so that the plasma P does not protrude from the substrate W while the plasma P is generated to as wide an extent on the surface of the substrate W as possible.

As illustrated in Fig. 2, the magnetic field generation unit 8 is provided with an inside magnet 13 arranged in a bar shape, and an annular outside magnet 14 arranged in a rectangular shape to surround the inside magnet 13.

The inside magnet 13 in a bar shape is a magnet in a bar shape elongate along a direction parallel with the shaft center of the deposition roller 2 as shown in Figs. 2 and 3A, and is formed by arranging multiple (four in the illustrated example) magnets in a rectangular parallelopiped shape so that the directions of the magnetic poles thereof (such as N poles) are aligned. Though the shape of the magnets may not necessarily be a rectangular parallelopiped shape, and may be a cylindrical shape, magnets in a rectangular parallelopiped shape are easily attached. Though the direction of the magnetic pole of the inside magnet 13 may be either the N pole or the S pole, the polarity is opposite to that of the outside magnet. On this occasion, for the sake of description, a description will be given of an example in which the direction perpendicular to the shaft center of the deposition roller 2, and departing from the shaft center (radially outward direction) is set to the N pole, and the opposite direction (radially inward direction) is set to the S pole.

The outside magnet 14 is formed by aligning multiple (14 in the illustrated example) magnets in approximately the same shape as those used for the inside magnet 13 so that the magnetic poles (S pole is directed radially outward) are aligned in a direction opposite to that of the inside magnet 13, arranging the magnets in the rectangular annular shape, and connecting the magnets with each other. Though the shape of the magnets of the outside magnet 14 may not necessarily be a rectangular parallelopiped shape, and may be a cylindrical shape, magnets in a rectangular parallelopiped shape are easily attached.

The inside magnet 13 and the outside magnet 14 are arranged on an installation board 15 in a flat plate shape, and the outside magnet 14 is arranged around the inside magnet 13 so as to be separated by a predetermined interval, thereby generating the magnetic field generation unit 8.

In other words, the magnetic field generation unit 8 is arranged inside the deposition roller 2 so that the inside magnet 13 directs the N pole toward the opposing space 3 (outside), and the annular outside magnet 14 directs the S pole toward the opposing space 3. The magnetic field generation unit 8 configured in this way generates a magnetron magnetic field in a region along the annular outside magnet 14 so as to surround the inside magnet 13.

Referring to Fig. 3B, a description is further given of the configuration of the inside magnet 13 and the outside magnet 14 of the magnetic field generation unit 8 arranged inside the deposition roller 2.

The substrate W wound on the deposition roller 2 covers the center portion 2c of the deposition roller 2, and partially covers the shield members 18 on the both ends in the widthwise direction. The inside magnet 13 is arranged so that the width in the shaft center direction thereof corresponds to the width of the center portion 2c in the deposition roller 2 in this state. In other words, the width on the shaft center direction of the inside magnet 13 (width of the inside magnet 13) is narrower than the width of the substrate W, and the inside magnet 13 is completely contained in the substrate W in a projection viewed from the deposition surface of the substrate W. In other words, the inside magnet 13 is formed so as to be narrower in width along the axial direction of the deposition roller 2 than the extent of the substrate W wound on the deposition roller 2 in the projection viewed from the deposition surface of the substrate W, and is arranged within the extent of the winding of the substrate W. In addition, the inside magnet 13 is arranged at the center in the widthwise direction within the extent of the substrate W wound on the deposition roller 2.

The magnetic field generated from the inside magnet 13 generates the plasma P on the substrate W, thereby depositing the coating, and the inside magnet 13 is preferably as long as possible, and as wide as possible in the axial direction of the deposition roller 2 in order to extend an effective deposition width on the substrate W. However, if the inside magnet 13 is wider than the extent of the winding of the substrate W in the axial direction of the deposition roller 2, the plasma P protrudes from the substrate W, thereby causing a damage of the substrate W and an unnecessary coating on the roller sides, which is not preferred. Conversely, if the inside magnet 13 is too short, the generated region of the plasma P becomes narrow, thereby reducing productivity, which is not preferred. Therefore, the width of the inside magnet is designed so as to be narrower more or less than the width of the substrate W, the width is preferably narrower than the width of the substrate W by 5mm to 200mm, and more preferably narrower by 50mm to 100mm.

The annular outside magnet 14 arranged so as to surround the periphery of the inside magnet 13 in the rectangular form generates the magnetron magnetic field, and while the positions of the inside magnet 13 and the outside magnet 14 are adjusted so that annular plasma is generated as wide on the substrate W as possible, the annular plasma P is prevented from protruding from the substrate W.

The arrangement of the inside magnet 13 and the outside magnet 14 is also adjusted considering the directions of the magnetic field at the edges of the substrate W. If the edges of the substrate W in contact with the deposition roller 2 is exposed to strong plasma P, the sides loose the insulating property, a large current flows from the plasma P to the deposition roller through surfaces of the edges of the substrate W, resulting in generation of abnormal discharge. The abnormal discharge damages the edges of the substrate W by heat or the like, resulting in a fatal damage on the substrate W.

The electrons in the plasma move along the magnetic field, and if the magnetic field in the edges of the substrate W extends to the generated area of the strong plasma P in a neighborhood of the center of the deposition roller 2, the electrons as well as ions in the plasma P are pulled into the edges of the substrate W, resulting in abnormal discharge on the edges of the substrate W. Conversely, for the magnet configuration in which the magnetic field on the edges of the substrate W extends toward the end side of the deposition roller 2, the gradient of magnetic lines are inclined toward the outside of the substrate W, namely toward the ends of the deposition roller 2 as viewed in a direction from the outside magnet 14 to the inside magnet 13, the magnetic lines of force connect to a space in the neighborhood of the ends of the deposition roller 2 having very weak plasma, the plasma on the edges of the substrate W can be maintained to be weak without the electrons and the ions being pulled in, the abnormal discharge on the edges of the substrate W can be reduced, and even if a high electric power is provided, the plasma P can be stably generated.

In other words, the magnetic field generation unit 8 is configured so that the magnetic lines of force extending toward the outside of the roller on the edges of the substrate W in contact with the deposition roller 2 incline toward the edges of the deposition roller 2, the plasma on the edges of the substrate W can be maintained to be weak, and the abnormal discharge can be reduced on the edges of the substrate W.

As described above, the abnormal discharge on the edges of the substrate W can be restrained by such a configuration that the magnetic lines of force extending toward the outside of the deposition roller 2 on the edges of the substrate W are inclined toward the ends of the roller. The reduction of the abnormal discharge can prevent the damage on the substrate, and can prevent the disappearance or the instability of the annular plasma P.

The above-described action is realized by properly adjusting a relative positional relationship between the inside magnet 13 and the outside magnet 14, and the distances from the surface of the deposition roller 2 to inside magnet 13 and the outside magnet 14. The position of the outside magnet 14 needs to be determined considering this point, and the width of the outside magnet 14 may be wider or narrower than the width of the substrate W.

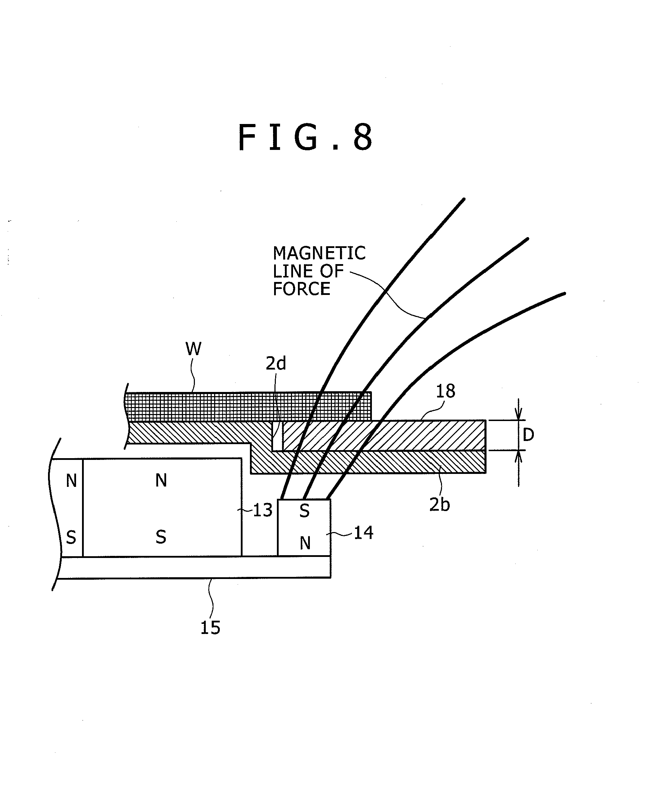

The outside magnet 14 is formed so as to be narrower in width along the axial direction of the deposition roller 2 than the extent of the substrate W wound on the deposition roller 2 in the projection viewed from the deposition surface of the substrate W, and is arranged within the extent of the winding of the substrate W as shown in Fig. 8. The configuration in which the outside magnet 14 is narrower than the width of the substrate W is easier for providing the design in which magnetic lines of force as exemplified by three magnetic lines of force in Fig. 8 are inclined toward the end direction of the deposition roller 2 and is thus preferable, and the width of the outside magnet is preferably shorter by 0 to 50 mm than the width of the substrate W. A heater or a temperature adjustment medium may be installed or may be passed between the deposition roller 2 and the magnets so as to adjust the temperature of the roller surface in a range -50°C to 300°C in order to control the temperature of the substrate W, and a cover may need to be provided around the magnets to protect the magnets from the medium or the heat. In this way, if the distance between the surface of the deposition roller 2 and the magnets increases due to an interposition of various structures, the shapes of the magnetic lines of force change on the surface of the deposition roller 2, the inclination of the magnetic lines of force viewed in the direction from the outside magnet 14 toward the inside magnet 13 is more preferably toward the outside of the substrate W by reducing the width of the outside magnet by 10 to 30 mm with respect to the width of the substrate W.

The magnetic lines of force in the swelling shape from the inside magnet 13 to the outside magnet 14 are configured to exit from and enter the surface of the deposition roller 2, and a force of an electromagnetic field resulting from the electric field provided for the deposition roller 2 and the magnetic lines of force in the swelling shape move the electrons present in the plasma P so as to orbit in the annular plasma P generated near the deposition roller 2. As a result of the movement of the electrons, the uniform plasma P with respect to the axial direction of the deposition roller 2 can be maintained, and the distribution of the deposited coating can also be uniform.

If the Penning discharge disclosed in Published Japanese Translation of PCT application No. 2005-504880 is used, magnetic lines of force exiting from a deposition roller extend to a roller on the opposite side, and the magnetic lines of force do not exit from and enter the surface of the deposition roller 2. The plasma P is generated at the location separated from the deposition roller 2, and the plasma P does not deposit a fine coating. Moreover, this configuration does not include the outside magnet 14, and cannot control the magnetic field at the edges of the substrate thereby actively preventing the substrate sides from being damaged, and controlling the coating thickness in the neighborhoods of the edges of the substrate.

The advantage of the present invention of enabling the generation of the uniform strong plasma P near the deposition roller 2 provides the uniformity of the coating as well as provides a fine coating resulting from the plasma P close to the substrate W.

The height of the outside magnet 14 is preferably approximately the half of the height of the inside magnet 13, for example, and the outside magnet 14 and the inside magnet 13 are preferably installed on the same installation board 15 in order to adjust a magnetic flux. As a result of this configuration, even if magnets having the same area on the top surface and made of the same material are used for the outside magnet 14 and the inside magnet 13, the magnetic flux density of the outside magnet 14 can be smaller than that of the inside magnet 13, for example, can be approximately halved. If the magnetic flux density of the outside magnet 14 surrounding the inside magnet 13 is halved with respect to the magnetic flux density of the inside magnet 13, a magnetic field configuration in which the magnetic flux density provided by the entire inside magnet 13 and the magnetic flux density provided by the entire outside magnet 14 are approximately balanced can be provided for the magnet arrangement in which the number of magnets of the outside magnet 14 is approximately twice that of the inside magnet 13.

The magnetic lines of force can be prevented from leaking to the outside of the magnetic field generation unit 8 by providing the magnetic field configuration in which the magnetic flux density of the entire inside magnet 13 and the magnetic flux density of the entire outside magnet 14 are approximately balanced, namely the magnetic field configuration in which the total magnetic flux density of the outside magnet 14 and the total magnetic flux density of the inside magnet 13 are balanced, the discharge outside the annular plasma P can be restrained, unnecessary plasma discharge and deposition at locations other than the annular plasma P such as the roller sides can be restrained, and a coating in a good quality can be deposited while the abnormal discharge is reduced at the edges of the substrate W.

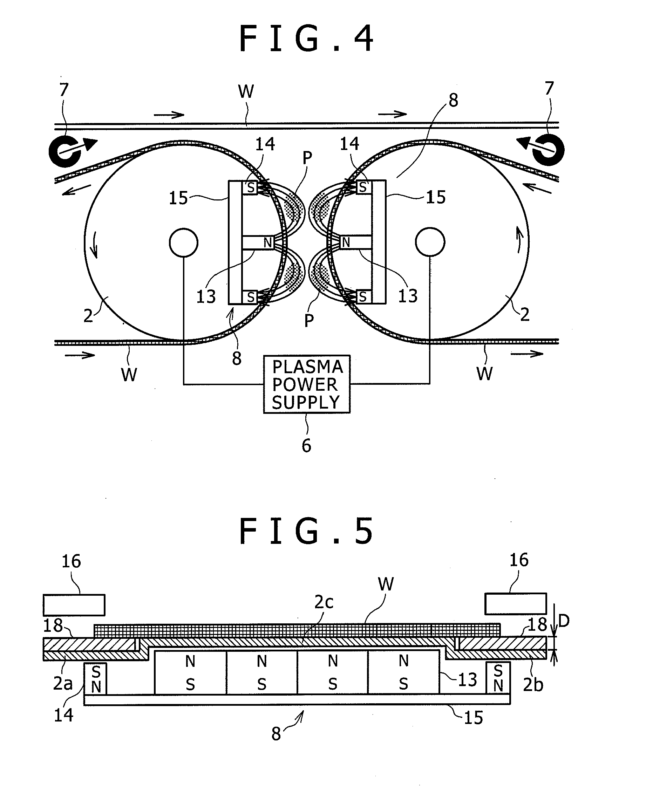

As described above, in the magnetic field generation unit 8 constructed by the inside magnet 13 and the outside magnet 14, both the N pole of the inside magnet 13 and the S pole of the annular outside magnet 14 direct to the opposing space 3 side, and the curved magnetic field in which the magnetic lines of force exiting from the N pole of the inside magnet 13 inside the deposition roller 2 to the outside of the deposition roller 2 enter again the inside of the deposition roller 2 while curving in an arc shape, and return to the S pole of the outside magnet 14 is generated (refer to Figs. 2 and 4).

The magnetic field generated by the magnetic field generation unit 8 generates the annular plasma P approximately uniform across the widthwise direction of the substrate W in front of the deposition roller 2 and the substrate W. The annular plasma P deposits the coating selectively only on the substrate W, restrains the deposition on the both end portions of the deposition roller 2, and can provide the uniform deposition across the widthwise direction of the substrate W. Moreover, the plasma P close to the edges of the substrate W can be restrained, thereby preventing the edges of the substrate W from being damaged, and the discharge can be maintained stably at a high electric power.

A detailed description will now be given of an operation of the plasma CVD apparatus 1 according to the present invention, namely, the method for depositing a coating on the substrate W using the above-described plasma CVD apparatus 1.

First, the deposition rollers 2 each covered by the shield members 18 made of an insulator and separated by the gaps L of 0.5-2.0mm from the step surface 2d on the sides 2a and 2b formed smaller in diameter than the center portion 2c are prepared, and the deposition rollers 2 are placed in the vacuum chamber 4. Then, the inside of the vacuum chamber 4 is once depressurized, and the source gas (organic silicon-based process gas such as HMDSO gas, oxygen gas, nitrogen gas, and argon gas) is then continuously supplied, thereby filling the source gas so that the inside of the vacuum chamber reaches a predetermined pressure. As the source gas, in addition to HMDSO, a silicon-based chemical compound such as TEOS, TMS, TDMAS, TMDSO, and silane and a metal organic compound such as titanium-base organic chemical compound such as titanium isopropoxide may be used, or ammonia, air, helium may be used.

When the source gas is filled in the vacuum chamber 4, the deposition rollers 2 are electrically connected to the plasma power supply 6, and a high-frequency AC voltage is impressed from the plasma power supply 6 on the deposition rollers 2. The glow discharge is generated by the impression of the voltage in the magnetic field space (magnetic field approximately uniformly generated in the substrate W) generated by the magnetic field generation unit 8, thereby generating the plasma P, and the source gas supplied to the vacuum chamber 4 is decomposed by the generated plasma P, and is accumulated as the CVD coating on the substrate W.

As described above, in the CVD apparatus 1 according to the present invention, the annular plasma P generated on the surface of the substrate W is generated approximately only on the substrate W, and the uniform deposition is provided across the widthwise direction on the substrate W while restraining the deposition on both the end portions of the deposition roller 2. Moreover, the plasma P is weak in the neighborhoods of the edges of the substrate, and the edges of the substrate can be prevented from being damaged.

If the thickness of the shield member 18 is approximately 5mm, for example, a high-frequency current will not flow through the shield member according to this embodiment, an unnecessary coating is prevented from being deposited on the shield member 18, and the unnecessary deposition can be more efficiently restrained on the end portions of the deposition roller 2.

Moreover, a strong electric field is hardly generated at the corner portions connecting the center portion 2c and the step surfaces 2d as a result of providing the gaps L of approximately 0.5 to 2.0mm between the portions at which the substrate W abuts against the roller metal and the shield member 18, thereby reducing the abnormal discharge.

In the CVD apparatus 1 according to this embodiment, the deposition operation may be safely carried out without providing the gaps L depending on the thickness of the shield member 18.

The above-described CVD apparatus 1 includes the characteristic configuration that the inside magnet 13 of the magnetic field generation unit 8 is formed so as to be narrower than the extent of the winding of the substrate W in the axial direction of the deposition roller 2, and is arranged within the extent of the winding of the substrate W. The annular plasma P thus deposits the uniform coating selectively only on the substrate W, restrains the deposition on the both end portions of the deposition roller 2, and can provide the uniform deposition across the widthwise direction of the substrate W. Moreover, the plasma P close to the edges of the substrate W can be restrained, thereby preventing the edges of the substrate W from being damages, and the discharge can be maintained stably at a high electric power.

### [Second Embodiment]

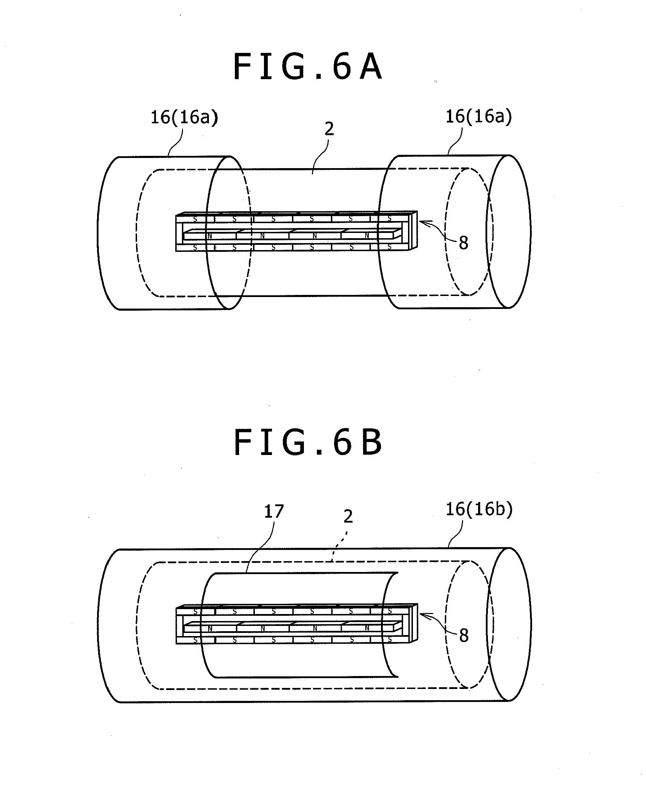

A description will now be given of a second embodiment of the present invention referring to Figs. 5 and 6.

The second embodiment has a significant characteristic that a mask 16 for covering the deposition roller 2 is provided in addition to the configuration of the first embodiment. In other words, the CVD apparatus 1 according to the second embodiment includes the mask 16 having an opening window narrower than the width of the substrate W, and is configured so that the mask 16 exposes the wound substrate W from the opening window, and covers the deposition roller 2 so as to cover the both ends of the substrate W in the widthwise direction.

Fig. 5 is a diagram showing the configuration according to the first embodiment illustrated in Fig. 3B to which an arrangement and a configuration of the mask 16 according to this embodiment is added.

The mask 16 is constructed by a metal or an insulating material such as a resin, includes an opening window (opening) in an annular shape formed on the substrate W as wide as the plasma P, and covers the edges of the substrate W. The position of the opening of the mask 16 corresponds to the position of the plasma P generated on the substrate W, does not block both the ends of the plasma P in the widthwise direction of the substrate W, and thus does not prevent the raw material for the coating generated by the plasma P from being deposited on the substrate W. Further, the mask 16 covers the edges of the substrate W, and the deposition on the deposition roller 2 outside the substrate W can thus be restrained.

If the mask 16 is made of a metal, the mask 16 is easily cleaned by means of blast processing, and the mask 16 after the cleaning can be reused. Though the electric potential of the mask 16 may not be fixed, namely may be floating, or may be controlled to be a determined electric potential, if the electric potential is designed to be equal to the electric potential of the vacuum chamber 4, a design of a fixing method becomes easy, and this configuration is thus preferred.

Moreover, the mask 16 may be constructed by a nonmagnetic metal. If the mask 16 is constructed by a nonmagnetic metal, the substrate W and the deposition roller 2 can be shielded without influencing the magnetic field generated by the magnetic field generation unit 8 inside the deposition roller 2.

Further, the mask 16 may be constructed by an insulating material such as a resin. The mask 16 constructed by an insulating material does not cause a current to flow, the coating quantity attached to the mask 16 can be minimized, and abnormal discharge generated between the mask 16 and the deposition roller 2 can be reduced.

Shape of the mask 16 includes two types which are shown in Fig. 6A and Fig. 6B, for example. Fig. 6A shows a state in which two masks 16 (16a) formed into a cylindrical shape shorter than the deposition roller 2 are provided, and the two masks 16a are arranged so as to cover the both ends of the deposition roller 2. The opening window is formed between the two masks 16a.

Fig. 6B shows a state in which the mask 16 (16b) is formed as a cylinder longer than the deposition roller 2, and an opening 17 in size approximately corresponding to the size of the annular plasma P generated on the substrate W is provided as the opening window on a side surface of the mask 16b. The mask 16b contains the deposition roller 2 in its inside, and is provided so that the opening 17 is arranged at the position at which the annular plasma P is generated. In other words, the opening 17 is provided at the position facing the magnetic field generation member 8 across the surface of the deposition roller 2, and exposes the wound substrate W from the opening 17. As a result, the substrate W can be masked in the travelling direction of the substrate W, and an unnecessary coating leaking from the annular plasma P, and appearing in the travelling direction of the substrate W can be prevented from being deposited.

In Figs. 6A and 6B, it should be understood that a slit for passing the transported substrate W is provided on the mask 16.

If the mask 16 is made of a metal, cooling means, which is not shown, is preferably provided. As the cooling means, a water-cooled pipe provided on the surface of the mask may be employed. If the metal mask 16 is cooled by the cooling means, the mask 16 can be prevented from being heated to a high temperature by radiant heat from the plasma P, and the substrate W close to the mask 16 can be protected from a damage by the heat.

The above-described CVD apparatus 1 according to the second embodiment includes the characteristic configuration that the inside magnet 13 of the magnetic field generation unit 8 is formed so as to be narrower than the extent of the winding of the substrate W in the axial direction of the deposition roller 2, and is arranged within the extent of the winding of the substrate W, and the mask including the opening window narrower than the width of the substrate W is provided. As a result, the CVD apparatus 1 can deposit a uniform coating on the substrate W, and can also restrain the quantity of the coating attached to the end portions of the deposition roller 2 as much as possible, thereby reducing the frequency of the maintenance.

By the way, it should be understood that the disclosed embodiments are examples in terms of all the points, and are not limitative. Particularly in the embodiments disclosed herein, items which are not explicitly disclosed such as operation conditions, measurement conditions, various parameters, dimensions, weights, volumes, and the like of the components do not depart from extents which a person skilled in the art normally embodies, and employ values which a normal person skilled in the art easily envisages.

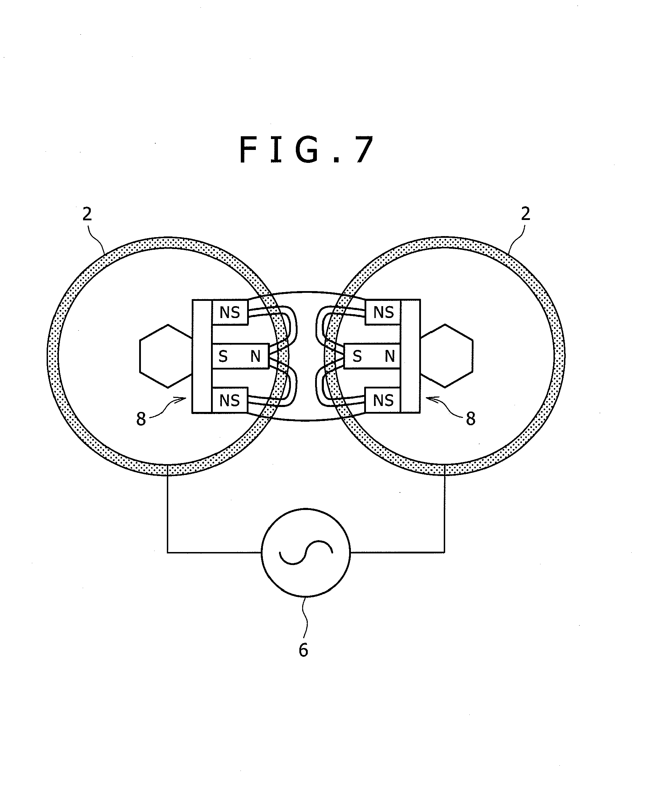

For example, the two magnetic field generation units 8 integrated into the pair of the deposition rollers 2 may be different in the configuration (arrangement of the poles) from each other as shown in Fig. 7.

Specifically, out of the two magnetic field generation units 8 opposing to each other, one magnetic field generation unit 8 is configured such that the magnetic pole of the inside magnet 13 is the N pole, and the magnetic pole of the outside magnet 14 is the S pole as described referring to Fig. 3A in the embodiment. Then, the other magnetic field generation unit 8 is configured so that the magnetic pole of the inside magnet 13 is the S pole, and the magnetic pole of the outside magnet 14 is the N pole, and the two magnetic field generation units 8 are opposed to each other as shown in Fig. 7.

In this way, if the two balanced-type magnetic field generation units 8 are opposed to each other, thereby providing a so-called absorption-type magnetic field configuration, the magnetic field leaking from each of the magnetic field generation units 8 is absorbed by the opposing magnetic field generation unit 8, and the leaking magnetic fields can be reduced. This leads to generation of more uniform annular plasma, and restraint of the plasma discharge on the end portions of the deposition roller 2.

Moreover, the plasma CVD apparatus 1 according to the embodiments of the present invention may include one or three or more deposition rollers 2.

Provided is a vacuum deposition apparatus including a vacuum chamber, a deposition roller that is arranged in the vacuum chamber, and winds a substrate in a sheet form subject to deposition, and a magnetic field generation unit that is provided inside the deposition roller, and generates a magnetic field on a surface of the deposition roller, where the magnetic field generation unit includes an inside magnet arranged along an axial direction of the deposition roller and an outside magnet having a polarity opposite to the inside magnet and surrounding, in an annular form, the inside magnet, and the inside magnet is formed so as to be narrower in width along the axial direction of the deposition roller than a width of an extent of winding of the substrate W on the deposition roller in a projection viewed from a deposition surface of the substrate, and is arranged within the extent of the winding of the substrate W.

## Claims

1. A vacuum deposition apparatus comprising:
a vacuum chamber;
a deposition roller that is arranged in the vacuum chamber, and winds a substrate in a sheet form subject to deposition;
a magnetic field generation unit that is provided inside the deposition roller, and generates a magnetic field on a surface of the deposition roller;
a gas supply unit that supplies a source gas into the vacuum chamber; and
a power supply that generates a discharge for bringing the source gas into plasma, wherein:
the magnetic field generation unit includes an inside magnet arranged along an axial direction of the deposition roller and an outside magnet having a polarity opposite to the inside magnet and surrounding the inside magnet in an annular form; and
the inside magnet is formed so as to be narrower in width along the axial direction of the deposition roller than a width of an extent of winding of the substrate on the deposition roller in a projection viewed from a deposition surface of the substrate, and is arranged within the extent of the winding of the substrate.

2. The vacuum deposition apparatus according to claim 1, wherein magnetic lines of force extending to the outside of the roller on an edge of the substrate in contact with the deposition roller is inclined toward the edge of the deposition roller as viewed in a direction from the outside magnet to the inside magnet.

3. The vacuum deposition apparatus according to claim 1, wherein:
an end portion of the deposition roller is provided with an insulator; and
the insulator covers the end portion of the deposition roller so that the outer diameter of said insulator is equal to the diameter of a center portion of said deposition roller.

4. The vacuum deposition apparatus according to claim 1, comprising two deposition rollers that are opposed to each other as the deposition roller.

5. The vacuum deposition apparatus according to claim 4, wherein the power supply is a mid-frequency AC power supply, one pole thereof is connected to one deposition roller, and the other pole is connected to the other deposition roller.

6. The vacuum deposition apparatus according to claim 1, comprising a mask that includes an opening window narrower than the width of the substrate, wherein the mask covers the deposition roller so as to cover both ends in a widthwise direction of the substrate and to expose the wound substrate from the opening window.

7. The vacuum deposition apparatus according to claim 6, wherein the mask is made of a metal, and is the same in electric potential as the vacuum chamber.

8. The vacuum deposition apparatus according to claim 7, wherein the mask is made of a nonmagnetic metal.

9. The vacuum deposition apparatus according to claim 6, wherein the mask is formed of an insulating material.

10. The vacuum deposition apparatus according to claim 6, wherein the mask includes an opening as the opening window, the opening is provided at a position opposed to the magnetic field generation unit across a surface of the deposition roller, exposes the wound substrate from the opening, and covers the deposition roller with a portion other than the opening along a travelling direction of the substrate.

11. The vacuum deposition apparatus according to claim 7, comprising cooling means that cools the mask.
